# EUROPÄISCHE PATENTSCHRIFT

(11) **EP 3 235 574 B1**
(45) Veröffentlichungstag und Bekanntmachung des Hinweises auf die Patenterteilung: **08.05.2019**
(21) Anmeldenummer: 17159445.0
(22) Anmeldetag: 06.03.2017
(51) Int. Cl.: B05B 17/00, B05D 1/00, B05B 13/04, B05D 1/02, B05D 1/30, G01N 30/94

(54) **DERIVATISIERUNGSGERÄT UND -VERFAHREN**
APPARATUS FOR DERIVATISATION AND PROCESS
APPAREIL POUR DÉRIVATISATION ET LE PROCÉDÉ

(30) Priorität: 19.04.2016 CH 5182016
(43) Veröffentlichungstag der Anmeldung: 25.10.2017
(73) Patentinhaber: CAMAG AG, 4132 Muttenz (CH)
(72) Erfinder: RICHERDT, Nicolas, 68730 Michelbach le bas (FR); REICH, Eike, 4310 Rheinfelden (CH); STURGESS, Mark Howell, 4054 Basel (CH); HALDEMANN, Diego Micha, 4410 Liestal (CH)
(74) Vertreter: Fleck, Hermann-Josef

(56) Entgegenhaltungen:
- WO-A1-99/55466
- DE-A1-102013 222 199
- US-A- 3 840 391
- US-A- 5 451 260

## Beschreibung

Die vorliegende Erfindung betrifft ein Derivatisierungsgerät gemäss Patentanspruch 1, sowie ein Derivatisierungsverfahren gemäss Patentanspruch 9.

Im Bereich der Dünnschichtchromatographie wird zur Derivatisierung der zu analysierenden Proben häufig der Probenträger in eine Lösung mit Reagenzien eingetaucht oder mit der Lösung besprüht, welche im Probenträger eindringt.

Das Besprühen hat gegenüber dem Eintauchen bekanntermassen den grossen Vorteil, dass die Messbereiche weniger oder gar nicht "verschmieren". Ein weiterer Vorteil ist der geringere Bedarf an Reagenzien welche als Lösungsmittel benötigt werden.

Um die besten Resultate zu erzielen bzw. damit die nachfolgende chemische Reaktion funktioniert, ist wünschenswert, dass die Reagenzlösung möglichst homogen verteilt auf dem gesamten Probenträger in einer optimalen Dosierung und Schichtdicke angebracht werden kann. Wird eine Sprühmethode angewendet, ist dies abhängig von der Art des verwendeten Sprühkopfes, sowie des Abstandes und der genauen Position des Sprühkopfes vom Probenträger. Um eine einheitlichere Verteilung zu erreichen ist auch möglich, den Sprühkopf über dem Probenträger derart zu bewegen, dass möglichst alle Bereiche gleichmässig besprüht werden.

Ein typisches Sprühverfahren erzeugt kleine Flüssigkeitströpfchen, welche auf den Probenträger aufgesprüht werden. Je nach Form des Sprühkopfes kann eine bestimmte Geometrie mehr oder weniger gleichmässig besprüht werden. Dadurch wird ein Flüssigkeitsfilm auf der Oberfläche des Probenträgers erzeugt, welcher die gewünschte Reaktion auslöst.

Neben dem direkten Besprühen des Probenträgers ist es auch möglich, mittels Sprühdüse einen Nebel aus feinen Tröpfchen zu bilden, welcher sich dann auf den Probenträger absenkt.

In WO 2006/114249 wird ein solches Verfahren und eine dafür geeignete Apparatur vorgestellt, welche durch die Vernebelung der Reagenzlösung eine Optimierung der homogenen Verteilung, sowie des Bedarfs an Reagenzien erreicht. Die Erzeugung der Flüssigkeitströpfchen erfolgt durch Ultraschallzerstäubung. Dabei wird in einem Flüssigkeitsbehältnis über der Flüssigkeit ein Nebelmeer erzeugt, welches sich anschliessend absenkt, so dass der gewünschte Flüssigkeitsfilm auf dem Probenträger abgelagert wird.

Die Grösse der Tropfen, welche mit einem Ultraschallzerstäuber erzeugt werden, ist abhängig von der Schwingungsfrequenz. Die Grösse der erzeugten Tropfen kann je nach gewählter Frequenz um bis zu 25% variieren. Dies führt zu einem relativ inhomogenen Nebelmeer, also auch zu einem inhomogenen Flüssigkeitsfilm auf dem Probenträger.

Um dieses Problem etwas zu vermindern, wird im vorgestellten Verfahren ein Tropfenabscheider verwendet, welcher benutzt wird, um diejenigen Tropfen, welche zu gross sind, oder von der Sprühdüse erzeugte Spritzer daran zu hindern, den Probenträger zu erreichen. Um trotzdem eine vollständige Überdeckung des Probenträgers mit einem Flüssigkeitsfilm der Reagenzlösung zu erreichen, muss also zu jedem Zeitpunkt im Verfahren ein Überschuss an Reagenzflüssigkeit vorhanden sein, welcher sich entweder im unteren Teil des Flüssigkeitsbehältnisses zur Erzeugung des Nebels befindet oder am Tropfenabscheider hängenbleibt bevor die Flüssigkeit wieder neben dem Probenträger in das Flüssigkeitsbehältnis hinunter tropft.

In der referenzierten Patentschrift wird zudem ein Gasein- und/oder -auslass gezeigt, welcher dazu dient, den erzeugten Nebel im Behälter zu verwirbeln, um eine bessere Durchmischung zur Beseitigung von Inhomogenitäten der Nebelverteilung zu erzielen.

Die vorliegende Erfindung stellt sich nunmehr die Aufgabe, ein Derivatisierungsverfahren und ein Derivatisierungsgerät der eingangs genannten Art derart zu verbessern, dass die Vorteile der bekannten Derivatisierungsverfahren und -geräte erhalten bleiben, die Tropfengrösse des erzeugten Nebels in einem engen Durchmesserbereich homogen ist, der Probenträger gleichmässig beschichtet wird, möglichst wenig Überschuss an Reagenzien benötigt wird und das Gerät auch für giftige oder stark reagierende Stoffe geeignet ist.

Diese Aufgabe löst ein Derivatisierungsgerät mit den Merkmalen des Patentanspruches 1. Weitere Merkmale und Ausführungsbeispiele gehen aus den abhängigen Ansprüchen hervor und deren Vorteile sind in der nachfolgenden Beschreibung erläutert.

In der Zeichnung zeigt:
- Fig 1: Anordnung des Derivatisierungsgeräts mit der Sprühdüse über dem Probenträger.
- Fig 2: Anordnung des Derivatisierungsgeräts mit der Sprühdüse neben dem Probenträger.
- Fig 3: Anordnung des Derivatisierungsgeräts mit beweglichem Probenträger
- Fig 4: Anordnung des Derivatisierungsgeräts mit einer Haube als Behälter
- Fig 5: Anordnung des Derivatisierungsgeräts mit bewegter Sprühdüse
- Fig 6: Stromlinien des Nebelmeers im Behälter
- Fig 7: Anordnung des Derivatisierungsgeräts mit spezieller gebogener Halterung für den Probenträger

Die Figuren stellen mögliche Ausführungsbeispiele dar, welche in der nachfolgenden Beschreibung erläutert werden.

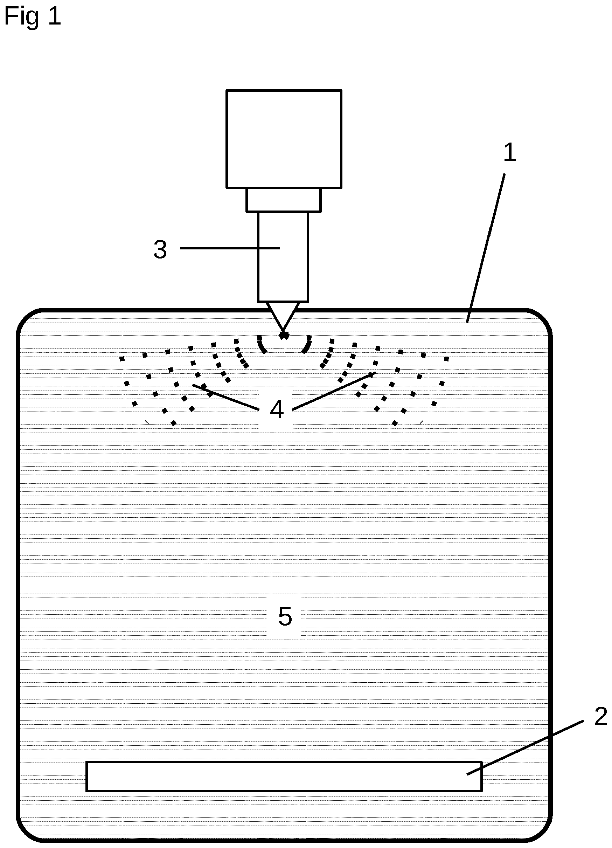

Die Vorrichtung der vorliegenden Erfindung ist ein Derivatisierungsgerät zur Beschichtung eines Probenträgers 2 mit einer Reagenzlösung. Das Derivatisierungsgerät in Fig. 1 besteht aus einem geschlossenen System in welchem eine kleine Menge Reagenzlösung über eine Sprühdüse 3 in einen dicht geschlossenen Behälter 1 gesprüht wird. Im geschlossenen Behälter 1 befindet sich ein Probenträger 2, welcher mit der Reagenzlösung möglichst homogen beschichtet werden soll.

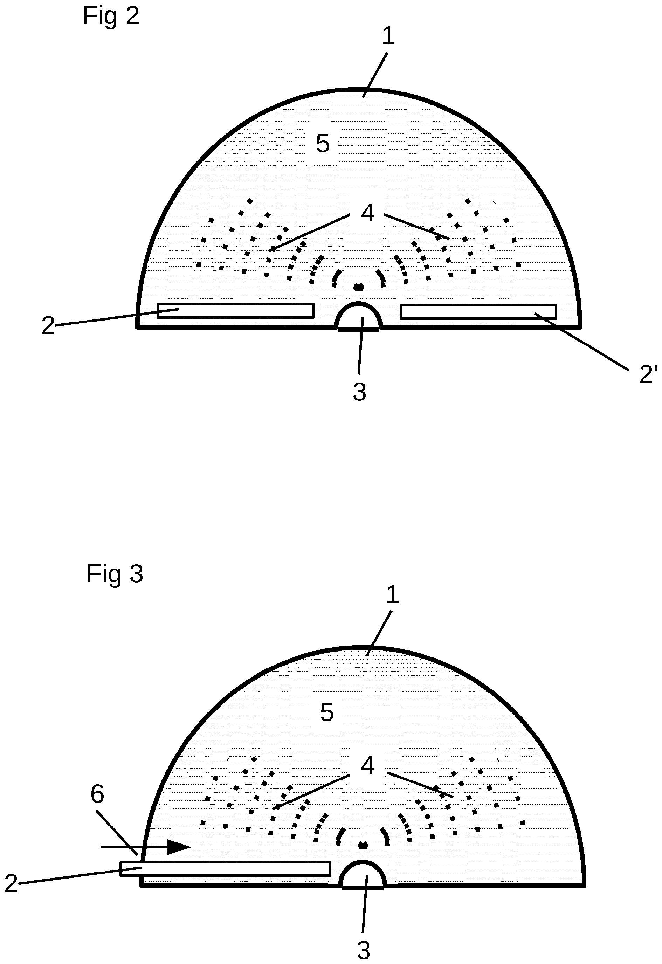

In Fig. 1 und 2 werden mögliche Anordnungen der Sprühdüse 3 gezeigt, welche zentriert am oberen bzw. unteren Rand in der Mitte des geschlossenen Behälters 1 angebracht sind. Weitere Anordnungen der Sprühdüse 3 in Richtung der Seitenwände des Behälters 1 (asymmetrisch) oder sogar an den Seitenwänden sind auch möglich. Die Sprühdüse 3 erzeugt ein homogenes Nebelmeer 5 aus Tröpfchen 4 der Reagenzlösung, wobei die Tröpfchen 4 eine einheitliche Grösse aufweisen. In der gezeigten Anordnung wird ein Tröpfchennebel 5 im oberen Bereich des Behälters 1 erzeugt. Durch die Schwerkraft senkt sich dieser Nebel 5 langsam ab und bildet eine homogene Flüssigkeitsschicht der Reagenzlösung auf dem Probenträger 2.

Idealerweise ist die Ausdehnung des Behälters 1 nur minimal grösser als die Ausdehnung des Probenträgers 2 um sicherzustellen, dass möglichst wenig der Reagenzlösung neben dem Probenträger 2 landet. Dies hat den grossen Vorteil, dass im Fall von sehr teuren oder sehr giftigen Reagenzlösungen möglichst wenig Überschuss benötigt wird, der anschliessend entsorgt werden muss oder mit grossen Aufwand zur weiteren Verwendung wieder eingesammelt und allenfalls aufbereitet werden muss.

In Fig. 2 wird eine weitere Anordnung des Derivatisierungsgeräts gezeigt. Der Behälter 1 weist die Form einer Halbkugel oder eine Glockenform auf. Weitere Formen wie z.B. die Hälfte eines Ellipsoids, ein Zylinder oder auch ein Würfel wie in Fig. 1 sind auch möglich. Die Sprühdüse 3 befindet sich bei dieser Ausführung im unteren Teil des Behälters 1, so dass die Tröpfchen 4 mit Hilfe der Sprühdüse 3 nach oben in das gesamte Volumen des Behälters 1 gesprüht werden, um das Nebelmeer 5 zu erzeugen. Dies hat gegenüber der Anordnung von Fig. 1 den Vorteil, dass alle Flüssigkeitströpfchen 4 zuerst nach oben gesprüht werden, wo sie dann in vertikaler Richtung kurz zum Stillstand kommen, bevor sie wieder langsam als Nebel 5 durch die Schwerkraft nach unten bewegt werden und schliesslich auf dem Probenträger 2 die gewünschte Beschichtung bilden. Der Probenträger 2 befindet sich bei dieser Anordnung neben der Sprühdüse 3, wobei die Sprühdüse 3 im Behälter 1 auch seitlich angeordnet sein kann, so dass ein grösserer Probenträger 2 im Behälter 1 Platz findet. Eine weitere Variante ist z.B. die Anordnung von zwei oder mehr Probenträgern 2, 2' um die Sprühdüse 3 herum, so dass alle gleichzeitig mit derselben Reagenzlösung besprüht werden können.

Eine wesentliche Anforderung an die vorliegende Erfindung ist, Verunreinigungen durch die Reagenzien und Verschleppungen zu vermeiden, die die Analysen verfälschen könnten. Verunreinigungen sind generell kritisch, haben aber vor allem dann zusätzliche Auswirkungen, wenn als Reagenzlösung eine giftige Substanz eingesetzt wird, die allenfalls die Probe oder sogar den Probenträger 2 oder andere Einrichtungen in der Umgebung zerstören kann.

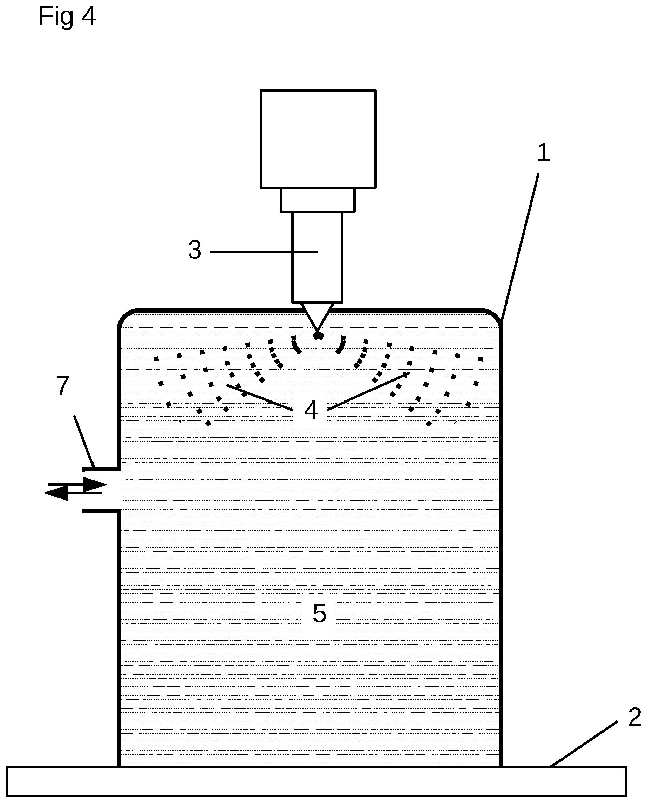

Verunreinigungen können vorkommen, sobald der Behälter 1 nach der Beschichtung geöffnet wird. Wenn sich das Nebelmeer 5 noch nicht komplett abgesenkt hat, können sich Reste des Nebelmeers 5 in der Umgebung verbreiten und ablagern. Um dies zu vermeiden, kann der Nebel 5 nach der Beschichtung und vor der Öffnung des Behälter 1 komplett abgesaugt und allenfalls sogar mit sauberer Luft wieder befüllt werden. Dies erfolgt über eine oder mehrere Entlüftungsöffnungen 7 und einer Absaugvorrichtung wie z.B. eine Pumpe (Figur 4).

Reagenzien können sich auch auf den Innenwänden des Behälters 1 ablagern. Bei der Beschichtung eines neuen Probenträgers 2 können diese einen unerwünschten Einfluss haben, vor allem wenn es sich um eine andere Reagenzflüssigkeit handelt, mit welcher das Nebelmeer 5 erzeugt wird. Eine Möglichkeit solche Ablagerungen zu vermeiden besteht darin, die Wände des Behälters 1 mit einem Material zu beschichten oder derart zu präparieren, so dass es für die Ablagerung der Tröpfchen 4 ungeeignet ist. Zudem soll der Behälter 1 spülmaschinenfest sein und leicht zu reinigen sein, damit allfällige Ablagerungen durch ein gründliches Waschen bestmöglich entfernt werden können.

Verschleppungen und Verunreinigungen kommen auch vor, wenn der Probenträger 2 aufgenommen und zur weiteren Bearbeitung transportiert wird. In den Ausführungsvarianten von Figur 1 und 2 wird der Probenträger 2 vom Behälter 1 komplett umschlossen und seine gesamte Oberfläche wird mit der Reagenzlösung beschichtet. Beim Fassen für den Transport des Probenträgers 2 wird Reagenzlösung auf dem Greifarm oder der Transportvorrichtung abgelagert, da diese in Kontakt mit dem Probenträger 2 kommen, welcher mit Reagenzflüssigkeit beschichtet ist. In dieser Ausführungsvariante ist zudem möglich, dass Tröpfchen 4 auch auf den anderen Flächen des Probenträgers 2 abgelagert werden, insbesondere auch auf der Unterseite. Dies wird dann problematisch, wenn der Probenträger 2 nach der erfolgten Beschichtung aus dem Derivatisierungsgerät wieder herausgenommen wird. Jedes Objekt, sei es z.B. ein Greifer oder ein Förderband, welches mit dem Probenträger 2 in Kontakt kommt, wird mit der Reagenzlösung verschmutzt und kann diese weiter verbreiten. Dies ist insbesondere bei giftigen Substanzen, aber auch in den vielen anderen Fällen unerwünscht. Mögliche Lösungen zeigen Figur 3 und Figur 4, wobei hier nur ein Teil des Probenträgers 2 sich während des Beschichtungsvorgangs innerhalb des geschlossenen Behälters 1 befindet. Am Teil des Probenträgers 2, welcher permanent ausserhalb des Behälters 1 ist, kann der beschichtete Probenträger 2 gefahrlos angefasst werden und zur weiteren Bearbeitung transportiert werden.

Um den Probenträger 2 bei der Ausführung von Figur 3 vor der Beschichtung in den Behälter 1 einzubringen, muss dieser eine Öffnung 6 aufweisen, durch welche der zu beschichtende Teil des Probenträgers 2 eingeführt wird. Damit die Oberfläche des Probenträgers 2 weder beim Einführen noch beim Entfernen innerhalb der Öffnung 6 den Behälter 1 berührt, muss die Öffnung grösser sein als die Ausdehnung des Probenträgers 2. Der Probenträger 2 und der Behälter 1 müssen im Bereich der Öffnung 6 derart ausgebildet sein, dass der Behälter 1 für den Sprühvorgang trotzdem geschlossen und dicht ist, um zu vermeiden, dass Reagenzlösung aus dem Behälter 1 austritt. Dies kann mit vielen bekannten Methoden erreicht werden. Möglich ist zum Beispiel eine Verbreiterung des Probenträgers 2 gegen aussen, so dass dieser die Dimension der Öffnung 6 übertrifft und diese komplett ausfüllt, oder es wird eine Erhebung auf dem Probenträger 2 angebracht, welche die Dimension der Öffnung 6 übertrifft, so dass diese nach Erhebung nach dem kompletten Einführen in durch die Öffnung, diese komplett schliesst. Um eine bessere Abdichtung zu erreichen können auch zusätzlich Teile aus anderem Material am Probenträger 2 oder um die Öffnung herum angebracht werden, wie zum Beispiel Dichtungen aus Gummi oder Kunststoff. Alternativ zur beschriebenen Methode mit einer Öffnung 6 im Behälter 1, kann dieser auch aus einer Haube 1 bestehen, die auf den Probenträger 2 herabgesenkt wird und darauf abgestellt wird (Figur 4). Dies kann entweder manuell oder mit Hilfe einer Maschine mit einem Motor gemacht werden. Ähnlich wie bei der Ausführungsvariante mit einer Öffnung 6 muss die Haube zusammen mit dem Probenträger 2 vor dem Sprühvorgang dicht geschlossen sein. Es wird also nur ein bestimmter Bereich der Oberseite des Probenträgers 2 im Behälter 1 isoliert, auf den sich die Reagenzien absetzen. Die Ränder und die Unterseite des Probenträgers 2 können dann ohne Gefahr, Reagenzien zu verschleppen, angefasst werden. Dies kann z.B. mit einem Greifer oder einem Förderband erfolgen.

Die Ausführungsformen in Figuren 3 und 4 erlauben auch, das vorgestellte Derivatisierungsgerät in einen halb- oder vollautomatischen Prozess zu integrieren, bei welchem der Probenträger 2 von einer Bearbeitungsstation zur nächsten transportiert wird. Dies kann z.B. manuell, mittels eines Förderbands oder einem Roboterarm erfolgen. Die in der Figur 3 dargestellte Öffnung 6 zeigt ein Anordnungsbeispiel, die Öffnung 6 kann aber auch an anderen Orten des Behälters 1 angebracht sein.

Auch im Bereich der Sprühdüse 3 muss sichergestellt werden, dass der Behälter 1 geschlossen und dicht ist. Eine Variante ist, die Sprühdüse 3 wie in Figur 2 angedeutet komplett im Behälter 1 anzuordnen. Dies bedingt, dass die Reagenzlösung, welche für die Beschichtung benötigt wird, in einem Reservoir der Sprühdüse 3 Platz findet, da die Reagenzlösung nicht von aussen hineingeführt werden kann. In Figur 1 befindet sich nur der Sprühkopf im Innern des Behälters 1, der restliche Teil der Sprühdüse 3, wie auch das Reservoir mit der Reagenzlösung, sind ausserhalb des Behälters 1 angebracht. Bei dieser Anordnung muss sichergestellt werden, dass der Behälter 1 im Bereich des Sprühkopfes dicht geschlossen ist.

Die folgenden Werte sind besonders entscheidend zur homogenen Beschichtung des Probenträgers 2 durch Erzeugung und Absenken eines Nebelmeers 5: die Tröpfchengrösse, die Abweichung der Tröpfchengrössen vom Zielwert und die homogene Verteilung der Tröpfchen 4 im Behälter 1.

Die gewünschte Tröpfchengrösse kann je nach Anwendung stark variieren, beispielsweise je nach Art der Reagenzlösung (insbesondere je nach Viskosität), oder gewünschte Homogenität: Je feiner die Tröpfchen und das Nebelmeer, desto langsamer ist das Beschichtungsverfahren und desto homogener ist die Beschichtung nach längeren Sprühzeiten. Für das vorliegende Beschichtungsverfahren sind Tröpfchen 4 mit einem Durchmesser kleiner als 12 µm von Vorteil, optimal im Bereich von 4 µm bis 12 µm.

Jeder Sprühkopf ist vorzugsweise auswechselbar und besteht aus einem porösen Material, dessen Porengrösse für einen bestimmten Einsatz geeignet ist. Die Porengrösse ist vorzugsweise einheitlich. Je kleiner die Poren und zähflüssiger die Reagenzlösung, desto schwieriger ist es, die Reagenzlösung durch den Sprühkopf zu treiben und Tröpfchen 4 zu erzeugen. Die Sprühköpfe werden also je nach Viskosität der Reagenzlösung und gewünschte Tropfengrösse angepasst.

Zur Erzeugung eines einheitlichen Nebelmeers 5 muss die Abweichung der Tröpfchengrössen vom Zielwert möglichst niedrig sein, vorzugsweise mit Toleranzen niedriger als 15%. Dafür kann z.B. eine Piezodüse 3 bzw. "vibrating mesh" Sprühdüse 3 eingesetzt werden. Bei der "vibrating mesh" Sprühdüse 3 wird im Sprühkopf eine Membran, beispielsweise aus einer Palladium Legierung, mit mehreren Tausenden (z.B. ca. 1000-7000) durch einen Laser erzeugten Poren vibriert, so dass ein Nebel 5 von kleinsten Tröpfchen 4 durch die Poren erzeugt wird. Die Membran wird durch Anregung der Sprühdüse 3 mit einer Wechselspannung, beispielsweise einer Sinusspannung, bei der Resonanzfrequenz in Vibration gesetzt. Die Amplitude der Vibrationen wird je nach der gewünschten Sprühmenge und/oder -geschwindigkeit angepasst. Je höher die Amplitude, desto höher der Durchfluss von Reagenzlösung durch die Membran.

In Versuchen hat sich gezeigt, dass eine homogene Verteilung der Tröpfchen 4 einfacher zu erreichen ist, wenn der Sprühkopf oder die Sprühdüse 3 im Behälter 1 bewegt wird. Die Bewegung kann zum Beispiel schwenkend, d.h. lateral hin und her, und/oder rotierend und/oder Schneckenförmig von aussen nach innen oder von innen nach aussen erfolgen. Grundsätzlich ist jede Art Bewegung möglich, wobei periodische Bewegungen jedoch eine bessere Homogenität der Beschichtung gewährleisten. Eine periodische Bewegung, beispielsweise mit gleicher Bewegungsgeschwindigkeit, erlaubt eine gleichmässige Besprühung des betreffenden Bereichs des Probenträgers 2. Zum Beispiel haben Pendelbewegungen mit einer Amplitude von +/- 30° bei einer Frequenz von 1 Hz gute Ergebnisse gezeigt.

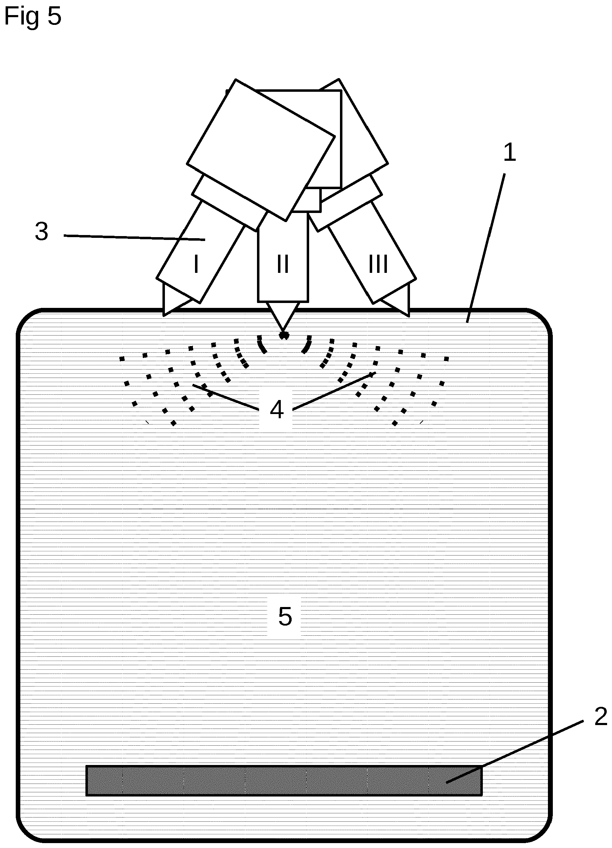

Eine Variante der Bewegung ist in Fig. 5 gezeigt. Hier wird die Sprühdüse 3 hin und her geschwenkt von der Position I über die Position II bis zur Position III und wieder zurück. Eine Bewegung in einer Ebene mit einer Abweichung von 10-30° von der Vertikalen hat sich als einfache und trotzdem effiziente Methode bewährt. Anstelle der Schwingung in nur einer Ebene sind auch beliebige andere Schwingungen in mehreren Richtungen möglich.

Ebenfalls hat sich gezeigt, dass der Abstand zwischen dem Probenträger 2 und dem Sprühkopf eine wichtige Rolle für die homogene Verteilung der Tröpfchen 4 spielt. Wenn der Probenträger 2 zu nah an dem Sprühkopf angeordnet ist, können sich die Tröpfchen 4 nicht über die ganze Fläche des Probenträgers 2 homogen verteilen, bevor sie sich darauf absenken. Dies führt auf dem Probenträger 2 zu einem Übermass an Reagenzlösung in der Nähe des Sprühkopfs, während sich in grösserer Entfernung des Sprühkopfs wesentlich weniger Reagenzlösung absenkt. Wird der Abstand zwischen dem Probenträger 2 und dem Sprühkopf stark vergrössert, wird einerseits das Derivatisierungsgerät unnötig gross und unhandlich und andererseits muss unter Umständen länger gewartet werden, bis sich die Tröpfchen 4 alle abgesenkt haben. In einer optimalen Ausführungsvariante beträgt dieser Abstand etwa 20 cm.

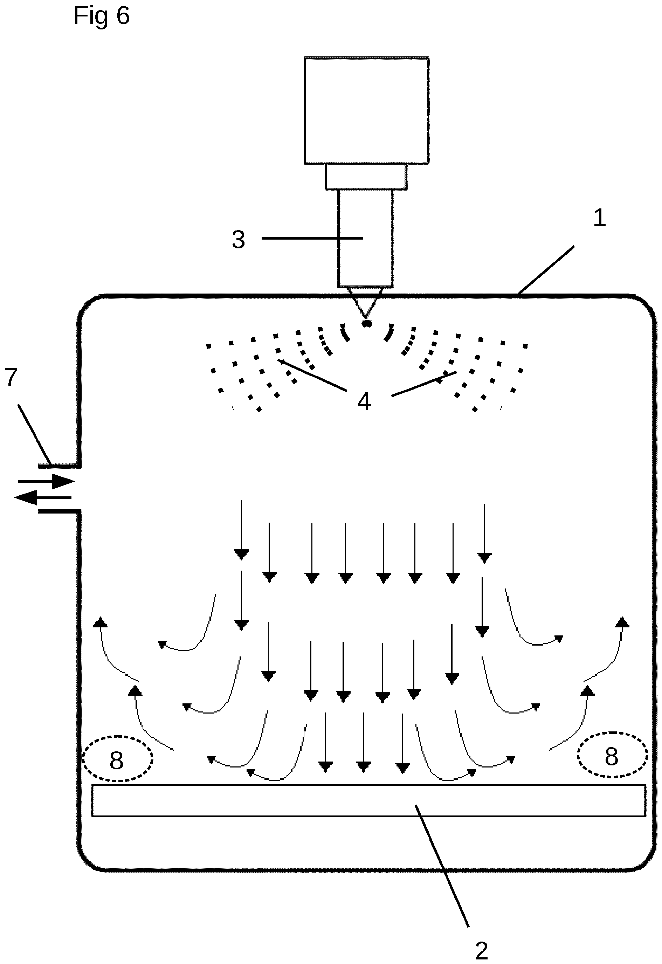

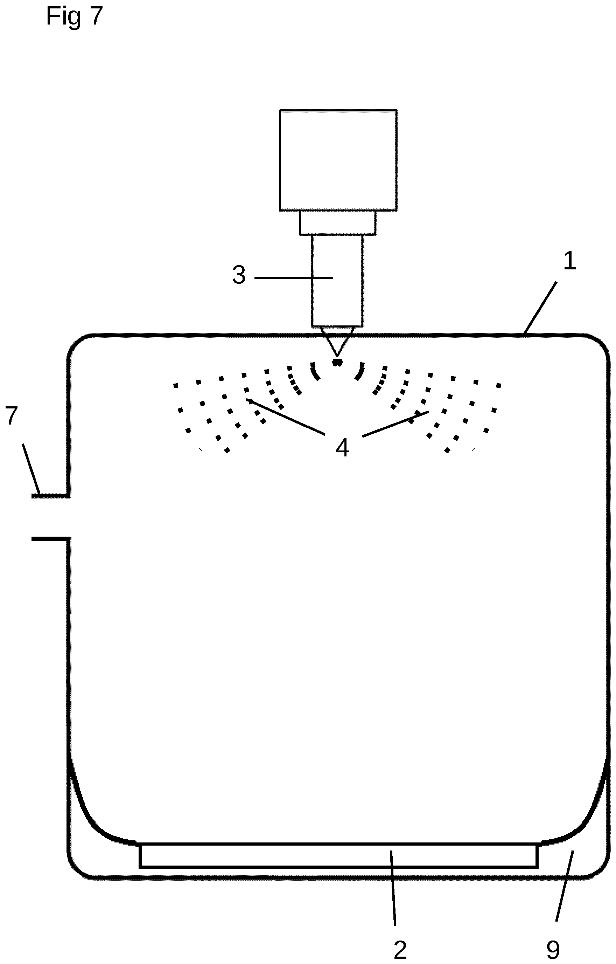

Die Geometrie des Probenträgers 2 ist für die Uniformität der Beschichtung wichtig: in Versuchen hat sich gezeigt, dass das Nebelmeer 5 bzw. die darin enthaltenen Tröpfchen 4 abhängig vom Ort im Behälter 1 unterschiedliche Geschwindigkeiten aufweisen. Im Randbereich 8 des Probenträgers 2 in der Nähe der Innenwand des Behälters 1 ist die Geschwindigkeit der Tröpfchen 4 quasi null (Figur 6). Dadurch werden in diesem Bereich weniger Tröpfchen 4 abgelagert. Um eine einheitlichere Beschichtung bis in den Randbereich 8 zu erreichen, kann der Probenträger 2 in einer möglichen Ausführungsvariante im Behälter 1 auf einer speziellen gebogenen Halterung 9 angeordnet werden (Figur 7). Dadurch werden zusätzliche Tröpfchen 4 vom Rand des Behälters 1 auf den Probenträger 2 umgeleitet, so dass die Menge der abgelagerten Tröpfchen 4 über den ganzen Probenträger 2 vereinheitlicht wird.

Die Kombination der oben beschriebenen Massnahmen ist entscheidend, um eine gleichmässige Menge Reagenzlösung auf den Probenträger 2 abzulagern. Durch die richtige Wahl der relevanten Parameter, d.h. der Porengrösse und/oder der elektrischen Anregung der vibrierenden Membran und/oder der Art der Bewegung der Sprühdüse 3 und/oder des Abstands zwischen der Düse 3 und/oder dem Probenträger 2, kann, unter Berücksichtigung der Viskosität der Reagenzlösung, ein Nebelmeer 5 mit Tröpfchen 4 einer präzisen Grösse, mit einer niedrigen Abweichung der Tröpfchengrössen vom Zielwert und mit einer homogenen Verteilung der Tröpfchen 4 erzeugt werden. Somit werden Probenträger mit lokalen Abweichungen der Menge aufgebrachter Reagenzlösung von weniger als 10 %, vorteilhaft weniger als 5 % und besonders vorteilhaft weniger als 2 % bereitgestellt.

Das Derivatisierungsverfahren mit dem beschriebenen Derivatisierungsgerät läuft in mehreren Phasen ab. In der ersten Phase, der sogenannten Sprühphase, wird eine kleine Menge Reagenzlösung mittels der Sprühdüse 3 in den Behälter 1 gesprüht um ein Nebelmeer 5 mit Tröpfchen 4 einheitlicher Grösse zu erzeugen. Mit der Sprühphase fängt auch gleich die Beschichtung des Probenträgers 2 an, durch allmähliche Absenkung der Tröpfchen 4. In der zweiten Phase, der passiven Absenkphase, wird nicht mehr gesprüht sondern gewartet, bis sich die übrigen Tröpfchen 4 des Nebelmeers 5 langsam absenken und auf dem Probenträger 2 die gewünschte homogene Beschichtung mit der Reagenzlösung bilden. Nach einer vordefinierten Zeit kann in einem nächsten Verfahrensschritt mittels einer Absaugvorrichtung das restliche Nebelmeer 5 abgesaugt werden, so dass nur die bereits abgesenkten Tröpfchen 4 im Behälter 1 bzw. auf dem Probenträger 2 bleiben. Gerade bei sehr kleinen Tröpfchen 4 ist dies hilfreich, um das Verfahren zu beschleunigen, da das Absenken sehr lange dauern kann. Hinzu kommt der Vorteil, dass nach dem Öffnen des Behälters 1 eine Verbreitung der Reagenzlösung in der Umgebung vermieden wird. Dies verhindert auch eine Verschleppung der Reagenzien, die nachfolgende Analysen verfälschen könnte.

Um das Ende der Sprühphase zu ermitteln, kann ein sogenannter End-of-Spray Zeitpunkt detektiert werden. Dieser End-of-Spray Zeitpunkt sollte möglichst genau dann angesetzt werden, wenn die Reagenzflüssigkeit komplett aufgebraucht ist. Dies vermeidet Schäden an der Sprühdüse 3 die entstehen können, wenn diese ohne Flüssigkeit weiterbetrieben wird. Der End-of-Spray Zeitpunkt kann abhängig vom Strom bzw. der Spannung ausgelöst werden, da sich der Energiebedarf zum Vibrieren der Membran verändert, sobald keine Reagenzlösung mehr in der Sprühdüse 3 vorhanden ist. Alternativ kann auch aufgrund von optischen Eigenschaften, z.B. mittels einer Lichtschranke festgestellt werden ob noch Lösung versprüht wird oder nicht. Sobald dieser End-of-Spray Zeitpunkt eingetroffen wird, wird die Sprühphase beendet.

Die Dauer der Sprühphase und der passiven Absenkphase ist abhängig von der verwendeten Reagenzlösung sowie der versprühten Menge. In einer möglichen Ausführungsvariante dauert die Sprühphase bis zu 10 Minuten und die passive Absenkphase bis zu 1 Minute. Bei dieser Ausführungsvariante dauert also das ganze Beschichtungsverfahren weniger als 11 Minuten. Zur Erzielung besonderer Beschichtungen können jedoch die Dauer der Sprühphase und/oder der passiven Absenkphase unabhängig voneinander verkürzt oder verlängert werden. Je nach Anwendung kann die Absenkphase sehr kurz sein oder auch länger als die Sprühphase. In gewissen Fällen ist auch möglich, das Ende der Absenkphase zu detektieren, z.B. optisch wenn kein Nebel 5 mehr im Behälter 1 sichtbar ist, oder auch mittels eines zusätzlich eingeführten Messgeräts, welches die Lichtdurchlässigkeit z.B. eines Laserstrahls oder eine andere Messgrösse ermittelt, aufgrund welcher bestimmt werden kann, dass möglichst alle Tröpfchen 4 sich abgesenkt haben.

Insbesondere wenn die Absenkphase eher lang ist und anzunehmen ist, dass ein Teil der Tröpfchen 4 sich noch nicht auf dem Probenträger 2 abgelagert hat und sich also noch im Behälter 1 befindet, macht es Sinn in einem zusätzlichen Prozessschritt die Reste der Reagenzflüssigkeit aus dem Behälter 1 abzusaugen. Dadurch kann die Zeit des gesamten Prozesses wesentlich verkürzt werden.

In einer weiteren Ausführungsvariante kann der Probenträger 2 gekühlt oder geheizt werden. Dadurch können bestimmte chemische oder physikalische Prozesse optimiert, beschleunigt oder gar erst ermöglicht werden die sonst nur teilweise oder gar nicht stattfinden. Die Kühlung oder Heizung kann über den Boden des Behälters 1 erfolgen. Auch die Wände des Behälters 1 könnten von Aussen oder über eine integrierte Heizung/Kühlung auf eine unterschiedliche Temperatur gebracht werden. Dies kann auch zusätzlich verhindern dass die Tröpfchen 4 sich an den Wänden des Behälters 1 ablagern. Die Heizung bzw. Kühlung des Probenträgers 2 sowie der Wände des Behälters 1 kann auch dazu verwendet werden ein Temperaturgefälle im Behälter 1 zu erzeugen, welcher die Absenkung des Nebelmeers 5 beschleunigt oder verlangsamt.

Je nach verwendeter Reagenzlösung kann oder muss die Sprühdüse 3 gereinigt werden. Neben der Reinigung des Behälters 1 ist dies ein wichtiger Schritt um Verschleppungen zu vermeiden. Für die Reinigung kann die Sprühdüse 3 mit einer neutralen Flüssigkeit oder mit einer speziellen Reinigungslösung betrieben werden.

Das vorgestellte Verfahren ist also sehr einfach, flexibel und effizient. Es wird nur eine geringe Menge Reagenzlösung benötigt um den Probenträger 2 vollständig zu beschichten. Das Verfahren ist für sehr unterschiedliche Reagenzien geeignet, insbesondere auch für sehr teure Reagenzlösungen, da nur wenig Material benötigt wird. Da der Behälter 1 während des Beschichtungsvorgangs geschlossen ist, können auch hochgiftige Reagenzlösungen eingesetzt werden, ohne dass aufwändige Sicherheitsmassnahmen nötig sind. Auch kann durch Verkürzung der Absenkphase mit anschliessendem Absaugen der restlichen Reagenzflüssigkeit die Zeit für die Beschichtung bei Bedarf reduziert werden.

Auch die Einbindung des Derivatisierungsverfahrens als einzelner Prozessschritt in einen kompletten Analyseprozess ist mit der vorgestellten Lösung problemlos möglich.

## Patentansprüche

1. Derivatisierungsgerät zur Beschichtung eines Probenträgers 2 vor der Analyse der Probe bestehend aus einem Reservoir für eine Reagenzlösung, einer Sprühdüse 3 mit einem Sprühkopf und einem Behälter 1 in welchem sich mindestens ein Teil des Probenträgers 2 befindet, wobei der Behälter 1 dicht geschlossen ist,
der Sprühkopf sich im Behälter befindet und eine periodische Bewegung ausführt, **dadurch gekennzeichnet, dass** der Sprühkopf im Behälter ein homogenes Nebelmeer 5 aus Tröpfchen 4 der Reagenzlösung erzeugt.

2. Derivatisierungsgerät gemäss Anspruch 1,
**dadurch gekennzeichnet, dass**
sich nur ein Teil des Probenträgers 2 innerhalb des geschlossenen Behälters 1 befindet.

3. Derivatisierungsgerät gemäss Anspruch 1,
**dadurch gekennzeichnet, dass**
der Behälter 1 aus einer Haube besteht, die auf den Probenträger 2 herabsenkbar ist.

4. Derivatisierungsgerät gemäss Anspruch 1,
**dadurch gekennzeichnet, dass**
die Wände des Behälters 1 aus einem Material bestehen, oder mit einem Material beschichtet sind, welches für die Ablagerung der Tröpfchen 4 ungeeignet ist.

5. Derivatisierungsgerät gemäss Anspruch 1,
**dadurch gekennzeichnet, dass**
der Sprühkopf eine Membran aus einem porösen Material enthält, welche eine einheitliche Porengrössen aufweist.

6. Derivatisierungsgerät gemäss Anspruch 5,
**dadurch gekennzeichnet, dass**
die Membran mit einer Wechselspannung anregbar und vibrierbar ist.

7. Derivatisierungsgerät gemäss Anspruch 1,
**dadurch gekennzeichnet, dass**
der Behälter 1 eine Entlüftungsöffnung 7 aufweist, welche mit einer Absaugvorrichtung verbunden ist.

8. Derivatisierungsgerät gemäss Anspruch 1,
**dadurch gekennzeichnet, dass**
durch eine geeignete Wahl der Art der Bewegung der Sprühdüse 3 und und des Abstands zwischen dem Sprühkopf und dem Probenträger 2 während der Besprühung eine homogene Verteilung der Tröpfchen 4 im Behälter 1 erreichbar ist.

9. Verfahren zur Beschichtung eines Probenträgers 2 mit dem Derivatisierungsgerät gemäss Anspruch 1,
wobei in einer ersten Sprühphase mittels des sich im Behälter befindenden und sich periodisch bewegenden Sprühkopfs im dicht geschlossenen Behälter 1 ein homogenes Nebelmeer 5 aus Tröpfchen 4 einer Reagenzlösung erzeugt,
in einer zweiten passiven Absenkphase sich das Nebelmeer 5 langsam absenkt und der Probenträger 2 mit einem homogenen Flüssigkeitsfilm der Reagenzlösung beschichtet wird.

10. Verfahren gemäss Anspruch 9,
wobei nur ein bestimmter Bereich des Probenträgers 2 beschichtet wird.

11. Verfahren gemäss Anspruch 9,
wobei vor jedem Einsatz der Sprühkopf mit der optimalen Porengrösse gewählt wird, in Abhängigkeit der Viskosität der Reagenzlösung und der gewünschten Tropfengrösse.

12. Verfahren gemäss Anspruch 9,
wobei der Behälter 2 vor der Sprühphase auf den Probenträger 2 abgesenkt wird und
nach der Absenkphase der Behälter 1 wieder angehoben und vom Probenträger 2 entfernt wird.

13. Verfahren gemäss einem der Ansprüche 9-12,
wobei nach der Absenkphase das sich noch im Behälter 1 befindende Nebelmeer 5 abgesaugt und entfernt wird.

14. Verfahren gemäss einem der Ansprüche 9-12,
wobei als zusätzlicher Schritt noch eine Reinigungsphase eingeführt wird, in der Reinigungsphase wird eine neutrale oder eine Reinigungsflüssigkeit durch die Sprühdüse 3 gesprüht und anschliessend wird der Behälter 1 gereinigt.

15. Verfahren gemäss Anspruch 9,
**dadurch gekennzeichnet, dass**
durch eine geeignete Wahl der Art der Bewegung der Sprühdüse 3 und des Abstands zwischen der Sprühdüse 3 und dem Probenträger 2 während der Besprühung eine homogene Verteilung der Tröpfchen 4 im Behälter 1 erreicht wird.

16. Verfahren gemäss Anspruch 9,
**dadurch gekennzeichnet, dass**
die lokalen Abweichungen der Menge aufgebrachter Reagenzlösung auf den Probenträger kleiner als 5 % sind.

17. Verfahren gemäss Anspruch 9,
**dadurch gekennzeichnet, dass**
der End-of-Spray Zeitpunkt optisch oder basierend auf geändertem Energiebedarf der Sprühdüse ermittelt wird.

## Claims

1. Apparatus for derivatisation for coating a sample carrier 2 before the analysis of the sample, consisting of a reservoir for a reagent solution, a spray nozzle 3 with a spray head and a container 1 in which at least part of the sample carrier 2 is located, wherein the container 1 is tightly closed, the spray head is located in the container and carries out a periodic movement,
**characterised in that**
the spray head produces a homogeneous mist 5 of droplets 4 of the reagent solution in the container.

2. Apparatus for derivatisation according to claim 1,
**characterised in that**
only part of the sample carrier 2 is located within the closed container 1.

3. Apparatus for derivatisation according to claim 1,
**characterised in that**
the container 1 consists of a hood, which can be lowered onto the sample carrier 2.

4. Apparatus for derivatisation according to claim 1,
**characterised in that**
the walls of the container 1 are made of a material or coated with a material which is not suitable for the deposition of the droplets 4.

5. Apparatus for derivatisation according to claim 1,
**characterised in that**
the spray head contains a membrane of a porous material which has a uniform pore size.

6. Apparatus for derivatisation according to claim 5,
**characterised in that**
the membrane can be excited and vibrated with an alternating voltage.

7. Apparatus for derivatisation according to claim 1,
**characterised in that**
the container 1 has a ventilation opening 7, which is connected to a suction device.

8. Apparatus for derivatisation according to claim 1,
**characterised in that**
by a suitable choice of the type of movement of the spray nozzle 3 and of the distance between the spray head and the sample carrier 2 during the spraying, a homogeneous distribution of the droplets 4 in the container 1 can be achieved.

9. Process for coating a sample carrier 2 with the apparatus for derivatisation according to claim 1,
wherein in a first spraying phase, by means of the spraying head located in the container and moving periodically in the tightly closed container 1, a homogeneous mist 5 of droplets 4 of a reagent solution is produced,
in a second passive settling phase, the mist 5 slowly settles and the sample carrier 2 is coated with a homogeneous liquid film of the reagent solution.

10. Process according to claim 9,
wherein only a certain area of the sample carrier 2 is coated.

11. Process according to claim 9,
wherein before each use, the spray head with the optimum pore size is selected, depending on the viscosity of the reagent solution and on the desired drop size.

12. Process according to claim 9,
wherein the container 2 is lowered onto the sample carrier 2 before the spraying phase and
the container 1 is raised again after the settling phase and removed from the sample carrier 2.

13. Process according to one of claims 9-12,
wherein after the settling phase, the mist 5 still remaining in the container 1 is sucked away and removed.

14. Process according to one of claims 9-12,
wherein a cleaning phase is introduced as an additional step,
in the cleaning phase, a neutral or a cleaning liquid is sprayed through the spray nozzle 3 and the container 1 is then cleaned.

15. Process according to claim 9
**characterised in that**
by a suitable choice of the type of movement of the spray nozzle 3 and of the distance between the spray head and the sample carrier 2 during the spraying, a homogeneous distribution of the droplets 4 in the container 1 is achieved.

16. Process according to claim 9,
**characterised in that**
the local variations of the amount of reagent solution applied onto the sample carrier are smaller than 5%.

17. Process according to claim 9,
**characterised in that**
the end-of-spray time is determined optically or based on a change of energy needs of the spray nozzle.

## Revendications

1. Appareil pour dérivatisation pour revêtir un porte-échantillon 2 avant l'analyse de l'échantillon, constitué d'un réservoir pour une solution de réactif, d'une buse de pulvérisation 3 avec une tête de pulvérisation et d'un conteneur 1 dans lequel se trouve au moins une partie du porte-échantillon 2, où le conteneur 1 est fermé hermétiquement et où la tête de pulvérisation se trouve dans le conteneur et effectue un mouvement périodique,
**caractérisé en ce que**
la tête de pulvérisation produit dans le conteneur un brouillard 5 de gouttelettes 4 de la solution de réactif.

2. Appareil pour dérivatisation selon la revendication 1,
**caractérisé en ce que**
seule une partie du porte-échantillon 2 se trouve à l'intérieur du conteneur fermé 1.

3. Appareil pour dérivatisation selon la revendication 1,
**caractérisé en ce que**
le conteneur 1 est constitué d'un capot pouvant être abaissé sur le porte-échantillon 2.

4. Appareil pour dérivatisation selon la revendication 1,
**caractérisé en ce que**
les parois du conteneur 1 sont constituées d'un matériau ou revêtues d'un matériau qui n'est pas adapté au dépôt des gouttelettes 4.

5. Appareil pour dérivatisation selon la revendication 1,
**caractérisé en ce que**
la tête de pulvérisation contient une membrane d'un matériau poreux présentant une taille de pores uniforme.

6. Appareil pour dérivatisation selon la revendication 5,
**caractérisé en ce que**
la membrane peut être excitée et vibrée avec une tension alternative.

7. Appareil pour dérivatisation selon la revendication 1,
**caractérisé en ce que**
le conteneur 1 comporte un évent 7 qui est relié à un dispositif d'aspiration.

8. Appareil pour dérivatisation selon la revendication 1,
**caractérisé en ce que**
par un choix approprié du type de mouvement de la buse de pulvérisation 3 et de la distance entre la tête de pulvérisation et le porte-échantillon 2 pendant la pulvérisation, une distribution homogène des gouttelettes 4 dans le conteneur 1 peut être obtenue.

9. Procédé de dérivatisation pour revêtir un porte-échantillon 2 avec l'appareil pour-dérivatisation selon la revendication 1,
dans lequel, dans une première phase de pulvérisation, au moyen de la tête de pulvérisation située dans le conteneur et se déplaçant périodiquement dans le conteneur hermétiquement fermé 1, un brouillard 5 homogène est produit à partir de gouttelettes 4 d'une solution de réactif,
dans une deuxième phase de dépôt passive, le brouillard 5 se dépose lentement et le porte-échantillon 2 est recouvert d'un film liquide homogène de la solution de réactif.

10. Procédé selon la revendication 9,
dans lequel seule une certaine zone du porte-échantillon 2 est revêtue.

11. Procédé selon la revendication 9,
dans lequel avant chaque utilisation, la tête de pulvérisation ayant la taille de pore optimale est sélectionnée en fonction de la viscosité de la solution de réactif et de la taille de goutte désirée.

12. Procédé selon la revendication 9,
dans lequel le conteneur 2 est abaissé sur le porte-échantillon 2 avant la phase de pulvérisation et
le conteneur 1 est relevé après la phase de dépôt et retiré du porte-échantillon 2.

13. Procédé selon l'une des revendications 9 à 12,
dans lequel, après la phase de dépôt, le brouillard 5 se trouvant encore dans le conteneur 1 est aspiré et éliminé.

14. Procédé selon l'une des revendications 9 à 12,
dans lequel, une phase de nettoyage est introduite comme étape supplémentaire,
dans phase de nettoyage, un liquide neutre ou de nettoyage est pulvérisé à travers la buse de pulvérisation 3, puis le conteneur 1 est nettoyé.

15. Procédé selon la revendication 9
**caractérisé en ce que**
par un choix approprié du type de mouvement de la buse de pulvérisation 3 et de la distance entre la tête de pulvérisation et le porte-échantillon 2 pendant la pulvérisation, une distribution homogène des gouttelettes 4 dans le conteneur 1 est obtenue.

16. Procédé selon la revendication 9,
**caractérisé en ce que**
les écarts locaux de la quantité de solution de réactif appliquée sur le porte-échantillon sont inférieurs à 5%.

17. Procédé selon la revendication 9,
**caractérisé en ce que**
le temps de fin de pulvérisation est déterminé optiquement ou sur la base d'un changement des besoins en énergie de la buse de pulvérisation.
